# EUROPEAN PATENT SPECIFICATION

(11) **EP 3 805 822 B1**
(45) Date of publication and mention of the grant of the patent: **26.08.2026**
(21) Application number: 19812017.2
(22) Date of filing: 28.05.2019
(51) Int. Cl.: G02B 5/22, C09B 57/00, C09B 67/48, C09B 67/46, C09B 67/20, C09B 67/22, C09D 5/32, C09D 17/00, G02B 5/20, G03F 7/00, G03F 7/033, G03F 7/037, G03F 7/004, G03F 7/105, C09D 7/41, C08K 5/00

(54) **COLORED RESIN COMPOSITION, PREPARING METHOD FOR SAME, NEAR-INFRARED TRANSMISSION LIGHT SHIELDING FILM, AND DECORATIVE SUBSTRATE**
GEFÄRBTE HARZZUSAMMENSETZUNG, VERFAHREN ZU IHRER HERSTELLUNG, NAHINFRAROTÜBERTAGUNGSLICHTABSCHIRMENDE SCHICHT UND DEKORATIVES SUBSTRAT
COMPOSITION DE RÉSINE COLORÉE, SON PROCÉDÉ DE PRÉPARATION, FILM DE PROTECTION CONTRE LA LUMIÈRE DE TRANSMISSION PROCHE INFRAROUGE ET SUBSTRAT DÉCORATIF

(30) Priority: 01.06.2018 JP 2018105802
(43) Date of publication of application: 14.04.2021
(73) Proprietor: Toray Industries, Inc., Tokyo 103-8666 (JP)
(72) Inventor: INOUE, Yoshihiko, Otsu-shi, Shiga 520-8558 (JP); NANBU, Kazuki, Otsu-shi, Shiga 520-8558 (JP); TOKUDA, Takuto, Otsu-shi, Shiga 520-8558 (JP)
(74) Representative: Hoefer & Partner Patentanwälte mbB
(86) International application number: PCT/JP2019/021004
(87) International publication number: WO 2019/230684

(56) References cited:
- WO-A1-2017/043428
- WO-A1-2018/034082
- WO-A1-2018/043085
- WO-A1-2018/056127
- WO-A1-2018/061781
- JP-A- 2015 185 096
- JP-A- 2017 116 955
- US-A1- 2015 293 282
- US-A1- 2017 010 528
- US-A1- 2018 057 690
- ANONYMOUS: "Bead Mill, Principle and Applications / Apex Mill series / Hiroshima Metal & Machinery", 12 August 2020 (2020-08-12), XP093182820, Retrieved from the Internet <URL:http://www.hiroshimamm-chemtech.com/en/knowledge/detail01/>

## Description

### TECHNICAL FIELD

The present invention relates to a near-infrared transmission light shielding film, and a decorative substrate.

### BACKGROUND ART

Various kinds of biometric authentication have been recently adopted in various information terminals such as smartphones and tablet PCs to enhance security. In addition to the conventional fingerprint authentication, face authentication, iris authentication, and the like have been studied, and for the face authentication and the iris authentication, near-infrared sensors and near-infrared cameras are used. Also in automobiles, near-infrared sensors such as motion sensors for display in the vehicle and near-infrared cameras such as driver monitoring cameras are used.

The above-described near-infrared sensors and near-infrared cameras are generally placed in the circumference of various displays and housings. Because a transparent or semi-transparent cover is used in the conventional near-infrared sensor and in the conventional near-infrared camera, there is a problem that the near-infrared sensor and the near-infrared camera are visually recognized from the outside to impair the design. Therefore, a filter and a paint have been studied to hide the near-infrared sensor and the near-infrared camera from the outside. The filter and the paint are required to have high near-infrared transmissivity and low visible light transmissivity. In the case that a dye that has been conventionally used as a colorant in general is used, the infrared transmissivity is sufficiently high but the light resistance is insufficient, and there is a problem that the optical property is deteriorated with time. Then, studies have been conducted on, for example, a laminate provided with a functional layer including at least a metal fine particle or a semi-metal fine particle having an average dispersed particle diameter of 1 to 100 nm capable of transmitting at least light in an infrared region and hiding light in a visible light region, an organic substance capable of being removed by baking, and a glass powder on a support (see, for example, Patent Document 1), and an optical filter provided with a structure containing a green pigment and a black pigment and satisfying that the average transmittance of light having a wavelength of 400 to 730 nm is 2% or less and that within the wavelength range of 800 to 1,000 nm, there is a continuous 50 nm wavelength range in which the average transmittance is 80% or more (see, for example, Patent Document 2).

Meanwhile, as a pigment having both high near-infrared transmissivity and a high visible light shielding property, a bisbenzofuranone-based pigment (see, for example, Patent Document 3) is known, and studies have been conducted on a bis-oxodihydroindoleylene-benzodifuranone colorant and a near-infrared inactive composition containing an isomer or a tautomer of bis-oxodihydroindoleylene-benzodifuranone (see, for example, Patent Document 4).
Patent Document 5 teaches a composition for color filter containing a near-infrared transmitting black coloring agent, a composition for color filter capable of forming an infrared transmission filter which is able to transmit an infrared ray in the state of low noise derived from the visible light component even when it has a very thin thickness, and an infrared transmission filter and a production method of an infrared transmission filter using the same, and an infrared sensor can be provided.
Patent Document 6 relates to a composition for an infrared transmission filter which can be used to produce an infrared transmission filter capable of transmitting infrared rays while having little noise originating from a visual light component even with extremely small thickness, and to an infrared transmission filter using the composition, a manufacturing method of the infrared transmission filter, and an infrared sensor.

### PRIOR ART DOCUMENTS

### PATENT DOCUMENTS

Patent Document 1: Japanese Patent Laid-open Publication No. 2016-191729
Patent Document 2: International Publication No. 2016/098810
Patent Document 3: Japanese Translation of PCT International Application Publication No. 2010-534726
Patent Document 4: Japanese Patent Laid-open Publication No. 2017-116955
Patent Document 5: US 2015/293282 A1
Patent Document 6: JP 2017-116955 A

### SUMMARY OF THE INVENTION

### PROBLEMS TO BE SOLVED BY THE INVENTION

However, although the techniques described in Patent Documents 1 and 2 in which the metal fine particle, the organic coloring pigment, and the organic black pigment are used provide good light resistance, it is difficult to achieve both a visible light shielding property and near-infrared transmissivity, and particularly, there is a problem that the image resolution of the near-infrared camera is significantly deteriorated due to the light scattering caused by the particle.

Therefore, an object of the present invention is to provide a near-infrared transmission light shielding film comprising a cured product of a colored resin composition that has excellent light resistance, a high visible light shielding property, and high near-infrared transmissivity, and causes little transmitted scattered light.

### SOLUTIONS TO THE PROBLEMS

As a result of intensive studies, the present inventors have found that the above-described problems can be solved by using a bisbenzofuranone-based pigment as a colorant of a colored resin composition and setting the crystallite size of the bisbenzofuranone-based pigment in the colored resin composition to a specific range, and completed the present invention, which is defined in the appended claims.

### EFFECTS OF THE INVENTION

The colored resin composition used according to the present invention is excellent in light transmissivity in the near-infrared region (wavelength: 800 to 1,000 nm), a light shielding property in the visible light region, and light resistance, and can reduce transmitted scattered light. With the colored resin composition used according to the present invention, an excellent near-infrared camera image can be obtained.

### BRIEF DESCRIPTION OF THE DRAWINGS

Fig. 1 is an X-ray diffraction profile of a bisbenzofuranone-based pigment Bk-1 and a bisbenzofuranone-based pigment Bk-2.
Fig. 2 is an X-ray diffraction profile of the colored films obtained in Example 3 and Comparative Example 1.

### EMBODIMENTS OF THE INVENTION

The colored resin composition used according to the present invention includes a resin (A), a colorant (B), and an organic solvent (C). The resin (A) has a function as a binder in the composition, the colorant (B) has a function of blocking visible light, and the organic solvent (C) has a function of dissolving or dispersing the resin (A) and/or the colorant (B) uniformly. The colored resin composition includes at least a bisbenzofuranone-based pigment as the colorant (B), and the bisbenzofuranone-based pigment has a crystallite size of 10 nm or more and 25 nm or less in a colored film consisting of a cured product of the colored resin composition. Here, the crystallite size is a value determined from the half width of the main peak appearing at a diffraction angle 2θ of 7.8° or more and 8.0° or less in the X-ray diffraction spectrum using a CuKα ray as an X-ray source.

The bisbenzofuranone-based pigment having both high near-infrared transmissivity and a high visible light shielding property is selected as the colorant (B) from pigments having excellent light resistance and is dispersed in the colored resin composition and the colored film so that the bisbenzofuranone-based pigment has a specific crystallite size to block visible light and, at the same time, to improve the near-infrared transmissivity significantly. Furthermore, because the scattering of the transmitted light can be suppressed, near-infrared scattered light can be suppressed, and a clear near-infrared camera image can be obtained through the colored film.

Examples of the resin (A) include epoxy resins, acrylic resins, siloxane resins, and polyimide resins. Two or more of these resins may be included. Among these resins, resins selected from the acrylic resins, the polyimide resins, and the siloxane resins are preferable from the viewpoints of the storage stability of the colored resin composition and the heat resistance of the colored film.

Although the colored resin composition used according to the present invention may or may not have photosensitivity, the colored resin composition can be provided with photosensitivity by using an alkali-soluble resin as the resin (A) and further including the photosensitizer (D) described below. Here, the word "alkali-soluble resin" in the present invention refers to a resin having a hydroxyl group and/or a carboxyl group as an alkali-soluble group, an acid value of 10 mg KOH/g or more, and a weight average molecular weight (Mw) of 500 or more and 150,000 or less. Here, the word "weight average molecular weight (Mw)" refers to a value determined by analysis by gel permeation chromatography using tetrahydrofuran as a carrier, and by calculation using a standard polystyrene calibration curve. The word "acid value" of the alkali-soluble resin refers to the value of the weight by mg of potassium hydroxide required to neutralize 1 g of the alkali-soluble resin (unit: mg KOH/g).

Examples of the alkali-soluble resin include cardo resins, acrylic resins, novolac resins, polyimide resins, polyimide precursors, polybenzoxazole resins, polybenzoxazole precursors, polyamide resins, and siloxane resins. In the case that the colored resin composition has negative photosensitivity, the acrylic resins and the polyimide resins are preferable from the viewpoints of pattern processability and coating film reliability, and the acrylic resins are more preferable from the viewpoint of dispersion stability. Meanwhile, in the case that the colored resin composition has positive photosensitivity, resins selected from the polyimide resins, the polyimide precursors, the polybenzoxazole resins, the polybenzoxazole precursors, and the siloxane resins are preferable from the viewpoint of pattern processability, and the polyimide resins and the polyimide precursors are more preferable from the viewpoint of the pattern processability.

The colored resin composition used according to the present invention includes at least a bisbenzofuranone-based pigment as the colorant (B). By using the bisbenzofuranone-based pigment as a colorant, the light resistance can be improved, and both a light shielding property in the visible light region and high light transmissivity in the near-infrared region can be achieved. The bisbenzofuranone-based pigment has a structure represented by any one of General Formulae (I) to (III) described below. Each of the structures represented by General Formulae (I) to (III) described below is a cis-trans isomer of another, and the bisbenzofuranone-based pigment may have two or more of these structures.

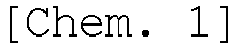

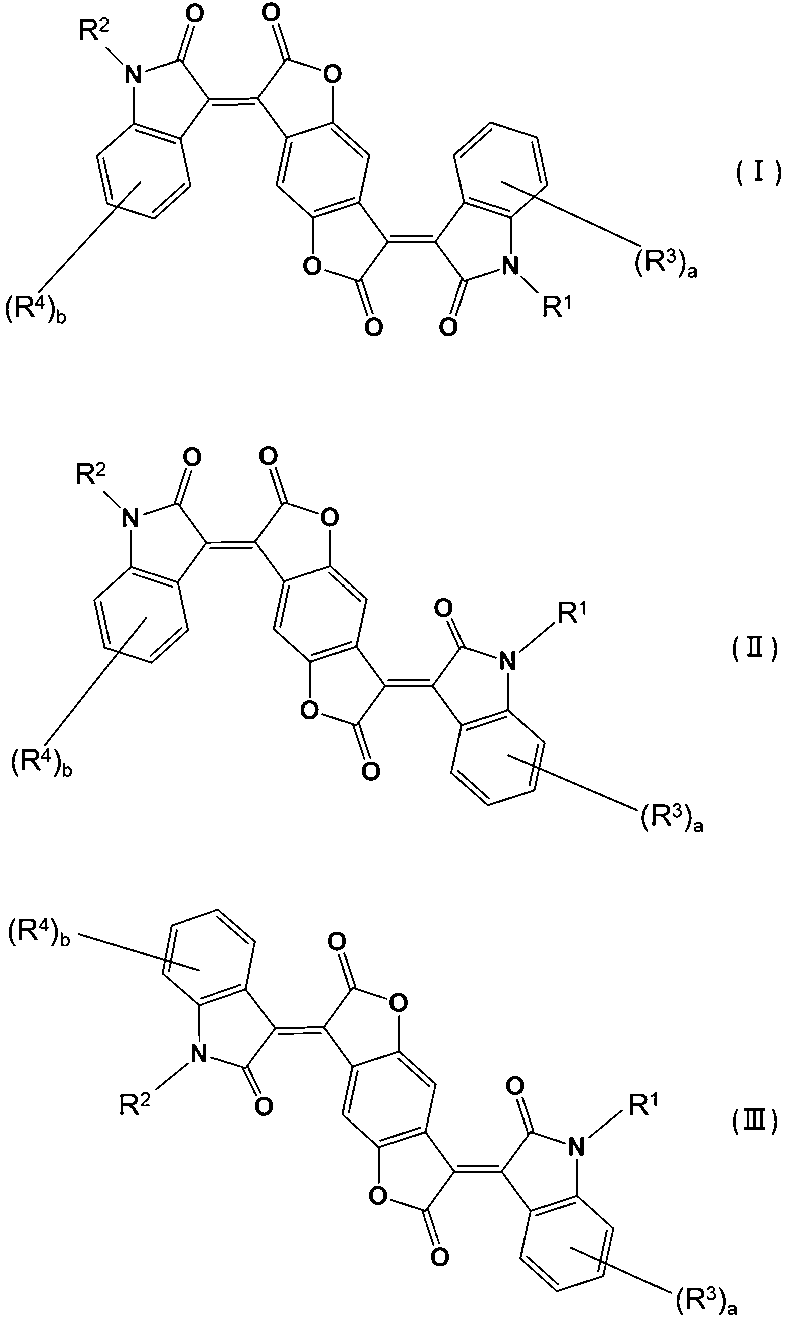

In General Formulae (I) to (III), R¹ and R² each independently represent a hydrogen atom or an alkyl group having 1 to 10 carbon atoms. R³ and R⁴ each independently represent R¹⁰, OR¹¹, SR¹¹, COR¹¹, CONR¹¹R¹², NR¹¹COR¹², OCOR¹¹, COOR¹¹, SCOR¹¹, OCSR¹¹, COSR¹¹, CSOR¹¹, CN, a halogen atom, or a hydroxyl group. Note that R¹⁰ represents an alkyl group having 1 to 20 carbon atoms, an aryl group having 6 to 30 carbon atoms, an arylalkyl group having 7 to 30 carbon atoms, or a heterocyclic group having 2 to 20 carbon atoms. R¹¹ and R¹² each independently represent a hydrogen atom, an alkyl group having 1 to 20 carbon atoms, an aryl group having 6 to 30 carbon atoms, an arylalkyl group having 7 to 30 carbon atoms, or a heterocyclic group having 2 to 20 carbon atoms. a and b each independently represent an integer of 0 to 4.

The bisbenzofuranone-based pigment itself having a structure represented by any one of General Formulae (I) to (III) described above is known, and can be produced by, for example, the method described in Japanese Patent Laid-open Publication No. 2012-515233. Furthermore, for example, the bisbenzofuranone-based pigment is commercially available as "Irgaphor" (registered trademark) Black S0100CF (trade name, manufactured by BASF SE).

In the X-ray diffraction spectra of the bisbenzofuranone-based pigment, the colored resin composition including the bisbenzofuranone-based pigment, and the colored film including the bisbenzofuranone-based pigment, the main peak having the highest intensity is observed at a diffraction angle 2θ of 7.8° or more and 8.0° or less using a CuKα ray as an X-ray source. From the half widths of these X-ray diffraction peaks, the crystallite size of the bisbenzofuranone-based pigment can be calculated by the Scherrer equation shown in Formula (1) below.
[Mathematical 1] $Crystallite size \left(nm\right) = \frac{Kλ}{β cos θ}$

In Formula (1) described above, K is a constant of 0.9, and λ is 0.15418 [nm]. β is represented by Formula (2) shown below.
[Mathematical 2] $β = \sqrt{{β}_{e}^{2} - {β}_{o}^{2}}$

In Formula (2) described above, βₑ is the half width of the diffraction peak, and β_{O} is the correction value of the half width (0.13 [°]). β, βe, and β_{O} are calculated in the radian.

The X-ray diffraction spectrum is measured by wide-angle X-ray diffraction using a CuKα ray as an X-ray source. As the X-ray diffractometer, for example, DS ADVANCE manufactured by Bruker AXS GmbH can be used. The measurement conditions are as follows. The output is 40 kV/40 mA, the slit system is Div. Slit: 0.3°, the measurement step (2θ) is 0.0171°, and the measurement time is 0.5 sec/step.

In the colored film including the cured product of the colored resin composition used according to the present invention, it is important that the bisbenzofuranone-based pigment has a crystallite size of 10 nm or more and 25 nm or less determined from the half width of the main peak appearing at a diffraction angle 2θ of 7.8° or more and 8.0° or less in the X-ray diffraction spectrum using a CuKα ray as an X-ray source. The crystallite size is an index of the dispersion state of the bisbenzofuranone-based pigment in the colored film, and the index indicates that the smaller the crystallite size is, the more finely the bisbenzofuranone-based pigment is dispersed in the colored film. Here, the colored film used in the present invention is a film including the cured product of the colored resin composition used according to the present invention. It is preferable that the crosslinkable group included in the resin (A) in the colored resin composition be crosslinked by heat and/or light and no crosslinkable group substantially remain in the colored film.

Such a colored film can be produced by forming a coating film of the colored resin composition on a substrate, drying the coating film with a hot plate or the like, and then heat-treating the dried coating film with a hot air oven or the like. For example, in the case that the colored resin composition includes an acrylic resin as the resin (A), the heat treatment temperature is preferably 170°C or more, and the heat treatment time is preferably 30 minutes or more.

In the case that the crystallite size of the bisbenzofuranone-based pigment in the colored film is more than 25 nm, the near-infrared transmissivity is deteriorated and the amount of the transmitted scattered light is increased, so that the clarity of the infrared camera image obtained through the colored film is deteriorated. The crystallite size of the bisbenzofuranone-based pigment is preferably 20 nm or less. In the case that the crystallite size of the bisbenzofuranone-based pigment in the colored film is less than 10 nm, it is difficult to stabilize the dispersion of the bisbenzofuranone-based pigment, the amount of the transmitted scattered light is increased due to the reaggregation of the pigment, and the visible light shielding property is deteriorated. As the method of setting the crystallite size of the bisbenzofuranone-based pigment in the colored film within the above-described range, it is preferable to stably and uniformly disperse the bisbenzofuranone-based pigment in the resin in a fine state without the reaggregation. More specific examples of the method include a method in which a bisbenzofuranone-based pigment having a small crystallite size is used and a method for producing the colored resin composition by the method in which the bead mill described below is used.

As the colorant (B), another colorant may be included together with the bisbenzofuranone-based pigment as long as the effect of the present invention is not impaired. Examples of the colorant other than the bisbenzofuranone-based pigment include organic pigments, inorganic pigments, and dyes that are generally used. In order to improve the heat resistance, the reliability, and the light resistance of the colored film, the organic pigments and the inorganic pigments are preferable.

Examples of the organic pigments include diketopyrrolopyrrole-based pigments; azo-based pigments such as azo pigments, disazo pigments, and polyazo pigments; phthalocyanine-based pigments such as copper phthalocyanine, halogenated copper phthalocyanine, and metal-free phthalocyanine; anthraquinone-based pigments such as aminoanthraquinone, diaminodianthraquinone, anthrapyrimidine, flavanthrone, anthanthrone, indanthrone, pyranthrone, and violanthrone; quinacridone-based pigments; dioxazine-based pigments; perinone-based pigments; perylene-based pigments; thioindigo-based pigments; isoindoline-based pigments; isoindolinone-based pigments; quinophthalone-based pigments; threne-based pigments; and metal complex-based pigments.

Examples of the inorganic pigments include titanium oxide, zinc white, zinc sulfide, white lead, calcium carbonate, precipitated barium sulfate, white carbon, alumina white, kaolin clay, talc, bentonite, black iron oxide, cadmium red, red iron oxide, molybdenum red, molybdate orange, chrome vermilion, chrome yellow, cadmium yellow, yellow iron oxide, titanium yellow, chromium oxide, viridian, cobalt titanate green, cobalt green, cobalt chromium green, victoria green, ultramarine blue, Prussian blue, cobalt blue, cerulean blue, cobalt silica blue, cobalt zinc silica blue, manganese violet, and cobalt violet.

Examples of the dyes include azo dyes, anthraquinone dyes, condensed polycyclic aromatic carbonyl dyes, indigoid dyes, carbonium dyes, phthalocyanine dyes, methine dyes, and polymethine dyes.

Examples of the black colorant include black organic pigments, mixed color organic pigments, and inorganic pigments. Examples of the black organic pigments include carbon black, perylene black, aniline black, and benzofuranone-based pigments. Examples of the mixed color organic pigments include pigments produced by mixing two or more pigments each having a color of red, blue, green, purple, yellow, magenta, cyan, or the like to make a pseudo black color. Examples of the black inorganic pigments include graphite; fine particles of metals such as titanium, copper, iron, manganese, cobalt, chromium, nickel, zinc, calcium, and silver; oxides, composite oxides, sulfides, nitrides, and oxynitrides of the above-described metals.

Examples of the white colorant include titanium dioxide, barium carbonate, zirconium oxide, calcium carbonate, barium sulfate, alumina white, and silicon dioxide.

Two or more of these colorants may be included. Among the colorants, blue colorants are preferable from the viewpoint of further improving the visible light shielding property of the colored film, and copper phthalocyanine is more preferable from the viewpoint of fastness.

In the case that the colorant other than the bisbenzofuranone-based pigment is included, the content of the colorant is preferably 5 parts by weight or more, and more preferably 20 parts by weight or more based on 100 parts by weight of the content of the bisbenzofuranone-based pigment. Meanwhile, from the viewpoints of further improving the near-infrared transmissivity and further suppressing the transmitted light scattering, the content of the colorant other than the bisbenzofuranone-based pigment is preferably 75 parts by weight or less, and more preferably 30 parts by weight or less based on 100 parts by weight of the content of the bisbenzofuranone-based pigment.

The content of the colorant (B) in the colored resin composition used according to the present invention is preferably 1 to 60% by weight in the solid content. Here, the word "solid content" refers to a component that is solid at room temperature among the components included in the colored resin composition. Examples of the component corresponding to the solid content include the resin (A) and the colorant (B), and the photosensitizer (D), the radically polymerizable compound (E), and other additives described below. By setting the content of the colorant (B) to 1% by weight or more, the visible light shielding property can be improved even in the case of the colored film having a thin thickness. The content of the colorant (B) is more preferably 10% by weight or more. By setting the content of the colorant (B) to 60% by weight or less, the dispersion stability of the colorant (B) can be improved. Furthermore, it is possible to suppress the reflection of the incident light at the interface between the colored film and the substrate, and further improve the near-infrared transmissivity. The content of the colorant (B) is preferably 40% by weight or less, and more preferably 17% by weight or less.

Examples of the organic solvent (C) include ethers, acetates, esters, ketones, aromatic hydrocarbons, amides, and alcohols.

Examples of the ethers include ethylene glycol monomethyl ether, ethylene glycol monoethyl ether, ethylene glycol mono-n-propyl ether, ethylene glycol mono-n-butyl ether, diethylene glycol monomethyl ether, diethylene glycol monoethyl ether, diethylene glycol mono-n-propyl ether, diethylene glycol mono-n-butyl ether, triethylene glycol monomethyl ether, triethylene glycol monoethyl ether, propylene glycol monomethyl ether, propylene glycol monoethyl ether, propylene glycol mono-n-propyl ether, propylene glycol mono-n-butyl ether, dipropylene glycol monomethyl ether, dipropylene glycol monoethyl ether, dipropylene glycol mono-n-propyl ether, dipropylene glycol mono-n-butyl ether, dipropylene glycol dimethyl ether, dipropylene glycol methyl-n-butyl ether, tripropylene glycol monomethyl ether, tripropylene glycol monoethyl ether, diethylene glycol dimethyl ether, diethylene glycol methyl ethyl ether, diethylene glycol diethyl ether, and tetrahydrofuran.

Examples of the acetates include butyl acetate, ethylene glycol monomethyl ether acetate, ethylene glycol monoethyl ether acetate, propylene glycol monomethyl ether acetate, 3-methoxybutyl acetate, ethylene glycol monobutyl ether acetate, diethylene glycol monomethyl ether acetate, diethylene glycol monoethyl ether acetate, diethylene glycol monobutyl ether acetate, cyclohexanol acetate, propylene glycol diacetate, propylene glycol monomethyl ether acetate, propylene glycol monoethyl ether acetate (hereinafter "PGMEA"), dipropylene glycol methyl ether acetate, 3-methoxy-3-methyl-1-butyl acetate, 1,4-butanediol diacetate, 1,3-butylene glycol diacetate, and 1,6-hexanediol diacetate.

Examples of the esters include alkyl lactates such as methyl 2-hydroxypropionate and ethyl 2-hydroxypropionate; ethyl 2-hydroxy-2-methylpropionate, methyl 3-methoxypropionate, ethyl 3-methoxypropionate, methyl 3-ethoxypropionate, ethyl 3-ethoxypropionate, ethyl ethoxyacetate, ethyl hydroxyacetate, methyl 2-hydroxy-3-methylbutanoate, 3-methoxybutyl acetate, 3-methyl-3-methoxybutyl acetate, 3-methyl-3-methoxybutylpropionate, ethyl acetate, n-propyl acetate, i-propyl acetate, n-butyl acetate, i-butyl acetate, n-pentyl formate, i-pentyl acetate, n-butyl propionate, ethyl butyrate, n-propyl butyrate, i-propyl butyrate, n-butyl butyrate, methyl pyruvate, ethyl pyruvate, n-propyl pyruvate, methyl acetoacetate, ethyl acetoacetate, and ethyl 2-oxobutanate.

Examples of the ketones include methyl ethyl ketone, cyclohexanone, 2-heptanone, and 3-heptanone.

Examples of the aromatic hydrocarbons include toluene and xylene.

Examples of the amides include N-methylpyrrolidone, N,N-dimethylformamide, and N,N-dimethylacetamide.

Examples of the alcohols include butyl alcohol, isobutyl alcohol, pentanol, 4-methyl-2-pentanol, 3-methyl-2-butanol, 3-methyl-3-methoxybutanol, and diacetone alcohol.

Two or more of these solvents may be included.

Among these organic solvents, the acetates are preferable in order to further disperse and stabilize the colorant. The content of the acetates in the organic solvent (C) is preferably 50 to 100% by weight, and more preferably 70 to 100% by weight.

With the increase in the size of the substrate on which a colored film is formed, an application in which a die coating apparatus is used is becoming a major method of forming a coating film of a colored resin composition on a substrate. Meanwhile, when a colored film is formed as a decorative film to decorate a cover glass or to hide a near-infrared sensor or a near-infrared camera, it is necessary to form the colored film on a small piece of glass, and an application in which an ink-jet apparatus is used is preferable. From the viewpoint of realizing suitable volatility and a suitable drying property in the application in which a die coating apparatus and an ink-jet apparatus are used, the colored resin composition preferably includes two or more organic solvents (C). From the viewpoints of uniforming the thickness of the coating film of the colored resin composition to improve the smoothness and the adhesiveness of the surface and suppressing dry foreign matter in the nozzles of the die coating apparatus and the ink-jet apparatus, the organic solvent (C) preferably includes an organic solvent having a boiling point of 150 to 200°C at a content of 30 to 75% by weight.

From the viewpoint of the thickness uniformity of the coating film in the application process, the content of the organic solvent (C) in the colored resin composition used according to the present invention is preferably 50% by weight or more, and more preferably 70% by weight or more. Meanwhile, from the viewpoint of suppressing pigment precipitation, the content of the organic solvent (C) is preferably 95% by weight or less, and more preferably 90% by weight or less.

The colored resin composition used according to the present invention can be provided with photosensitivity by including an alkali-soluble resin as the resin (A) and further including a photosensitizer (D). The colored resin composition may have photosensitivity with which the alkali solubility of the exposed portion is reduced by a pattern exposure through an exposure mask and the unexposed portion is removed with an alkaline developing solution to form a pattern, that is, negative photosensitivity, or may have photosensitivity with which the alkali solubility of the exposed portion is made higher than that of the unexposed portion by a pattern exposure through an exposure mask and the exposed portion is removed with an alkaline developing solution to form a pattern, that is, positive photosensitivity. The colored resin composition preferably has the negative photosensitivity because a pattern with high resolution is easily formed even if the light shielding property is high.

The colored resin composition can be provided with the negative photosensitivity with which the exposed portion is photocured by a radical polymerization reaction by including a photopolymerization initiator as the photosensitizer (D) and further including a radically polymerizable compound (E). The radically polymerizable compound (E) preferably has two or more radically polymerizable groups.

The word "photopolymerization initiator" refers to a compound that generates a radical by a bond cleavage and/or a reaction by an exposure. By making the colored resin composition include the photopolymerization initiator, the radically polymerizable compound (E) can be photocured by an exposure.

Examples of the photopolymerization initiator include carbazole-based photopolymerization initiators, acylphosphine oxide-based photopolymerization initiators, oxime ester-based photopolymerization initiators, and α-aminoalkylphenone-based photopolymerization initiators. Two or more of these photopolymerization initiators may be included. Among these photopolymerization initiators, the carbazole-based photopolymerization initiators and the oxime ester-based photopolymerization initiators are preferable because of their high sensitivity to a mixed line including i-line (365 nm), h-line (405 nm), and g-line (436 nm) in the exposure process described below.

From the viewpoint of improving the sensitivity to the exposure, the content of the photopolymerization initiator is preferably 1 part by weight or more based on 100 parts by weight of the total content of the alkali-soluble resin and the radically polymerizable compound (E). Meanwhile, from the viewpoint of the deep curability to the exposure, the content of the photopolymerization initiator is preferably 60 parts by weight or less, and more preferably 40 parts by weight or less based on 100 parts by weight of the total content of the alkali-soluble resin and the radically polymerizable compound (E).

From the viewpoints of improving the sensitivity during the exposure and improving the hardness of the colored film, the radically polymerizable compound (E) preferably has a (meth)acrylic group as the radically polymerizable group. Here, the word "(meth)acrylic group" refers to a methacrylic group or an acrylic group.

From the viewpoint of improving the sensitivity to the exposure, the content of the radically polymerizable compound (E) is preferably 5 parts by weight or more, and more preferably 15 parts by weight or more based on 100 parts by weight of the total content of the alkali-soluble resin and the radically polymerizable compound (E). Meanwhile, from the viewpoint of the reflowability in the curing process, the content of the radically polymerizable compound (E) is preferably 80 parts by weight or less, and preferably 60 parts by weight or less based on 100 parts by weight of the total content of the alkali-soluble resin and the radically polymerizable compound (E).

The colored resin composition can be provided with the positive photosensitivity by including a photoacid generator as the photosensitizer (D) to increase the alkali solubility of the exposed portion relatively.

As the photoacid generator, a quinonediazide compound is preferable. As the quinonediazide compound, an esterified product of a compound having a phenolic hydroxyl group and a quinonediazidesulfonyl acid chloride is more preferable. In order to improve the alkali solubility, some of the phenolic hydroxyl groups may be intentionally left without being esterified.

The content of the quinonediazide compound is preferably 1 to 50 parts by weight based on 100 parts by weight of the alkali-soluble resin from the viewpoint of the pattern processability.

The colored resin composition used according to the present invention preferably further includes a polymer dispersant. The word "polymer dispersant" refers to a material having both a pigment affinity group having a chemical bond or an adsorption action to the pigment surface and a polymer chain or group having a solvophilic property. In the wet media dispersion treatment described below, the polymer dispersant improves the wettability of a pigment to a dispersion medium to promote the deagglomeration of the pigment, and stabilizes the particle size and the viscosity by the steric hindrance and/or the electrostatic repulsion effect. In addition, the polymer dispersant has an effect of suppressing the occurrence of the color separation during the storage or the application of the colored resin composition.

Examples of the polymer dispersant include polyester-based polymer dispersants, acrylic-based polymer dispersants, polyurethane-based polymer dispersants, polyallylamine-based polymer dispersants, carbodiimide-based dispersants, and polyamide-based polymer dispersants. Among these polymer dispersants, the acrylic-based polymer dispersants and the polyamide-based polymer dispersants are more preferable. The polyamide-based polymer dispersant preferably has a comb structure having a plurality of side chains including a polyester chain. More specifically, a compound is preferable that has a structure, such as polyalkyleneimine, having a large number of nitrogen atoms in the main chain and has a plurality of side chains of a polyester chain amide-bonded via the nitrogen atoms. Examples of the polyamide-based dispersant having such a comb structure include "DISPERBYK" (registered trademark) 2200 (manufactured by BYK-Chemie GmbH) and "SOLSPERSE" (registered trademark) 11200, 28000 (all manufactured by The Lubrizol Corporation).

The polymer dispersants are classified into dispersants having an amine value of 1 mg KOH/g or more and an acid value of less than 1 mg KOH/g, dispersants having an acid value of 1 mg KOH/g or more and an amine value of less than 1 mg KOH/g, dispersants having an amine value of 1 mg KOH/g or more and an acid value of 1 mg KOH/g or more, and dispersants having an amine value of less than 1 mg KOH/g and an acid value of less than 1 mg KOH/g. Two or more of these photopolymerization initiators may be included. Among these dispersants, the dispersants having an amine value of 1 mg KOH/g or more are preferable.

Examples of the polymer dispersants having an amine value of 1 mg KOH/g or more and an acid value of less than 1 mg KOH/g include "DISPERBYK" (registered trademark) 102, 160, 161, 162, 2163, 164, 2164, 166, 167, 168, 2000, 2050, 2150, 2155, 9075, and 9077, "BYK" (registered trademark) -LP N6919, "DISPERBYK" (registered trademark) -LP N21116, and "DISPERBYK" (registered trademark) -LP N21234 (all of which are manufactured by BYK-Chemie GmbH), "EFKA " (registered trademark) 4015, 4020, 4046, 4047, 4050, 4055, 4060, 4080, 4300, 4330, 4340, 4400, 4401, 4402, 4403, and 4800 (all of which are manufactured by BASF SE), "AJISPER" (registered trademark) PB711 (manufactured by Ajinomoto Fine-Techno Co., Inc.), and "SOLSPERSE" (registered trademark) 13240, 13940, 20000, 71000, and 76500 (all of which are manufactured by The Lubrizol Corporation).

Examples of the polymer dispersants having an amine value of 1 mg KOH/g or more and an acid value of 1 mg KOH/g or more include "DISPERBYK" (registered trademark) 142, 145, 2001, 2010, 2020, 2025, and 9076, and Anti-Terra-205 (all of which are manufactured by BYK-Chemie GmbH), "SOLSPERSE" (registered trademark) 24000 (manufactured by The Lubrizol Corporation), "AJISPER" (registered trademark) PB821, PB880, and PB881 (all of which are manufactured by Ajinomoto Fine-Techno Co., Inc.), and "SOLSPERSE" (registered trademark) 9000, 11200, 13650, 24000SC, 24000GR, 32000, 32500, 32550, 326000, 33000, 34750, 35100, 35200, 37500, 39000, and 56000 (manufactured by The Lubrizol Corporation).

From the viewpoint of improving the dispersion stability, the content of the polymer dispersant in the colored resin composition used according to the present invention is preferably 10 parts by weight or more, and more preferably 20 parts by weight or more based on 100 parts by weight of the colorant (B) described below. Meanwhile, from the viewpoint of improving the heat resistance and the adhesion of the colored film, the content of the polymer dispersant is preferably 100 parts by weight or less, and more preferably 60 parts by weight or less based on 100 parts by weight of the colorant (B).

The colored resin composition used according to the present invention may include a thermal crosslinking agent. By making the colored resin composition include the thermal crosslinking agent, the finally obtained coating film strength can be improved. Examples of the thermal crosslinking agent include compounds having two or more alkoxymethyl groups and/or methylol groups, and compounds having two or more epoxy groups. Two or more of these photopolymerization initiators may be included.

The colored resin composition used according to the present invention may include a leveling agent. By making the colored resin composition include the leveling agent, the application property and the surface smoothness of the colored film can be improved. Examples of the leveling agent include anionic surfactants such as ammonium lauryl sulfate and triethanolamine polyoxyethylene alkyl ether sulfate; cationic surfactants such as stearylamine acetate and lauryltrimethylammonium chloride; amphoteric surfactants such as lauryldimethylamine oxide and laurylcarboxylmethylhydroxyethylimidazolium betaine; nonionic surfactants such as polyoxyethylene lauryl ether, polyoxyethylene stearyl ether, and sorbitan monostearate; silicone-based surfactants having polydimethylsiloxane or the like as a main skeleton; and fluorochemical surfactants. Two or more of these photopolymerization initiators may be included. Examples of the commercially available surfactants include "BYK" -302, "BYK" -333, "BYK" -3550, and "BYK" -392 (all of which are manufactured by BYK-Chemie GmbH).

When a colored film is formed to have an optical density (OD value) of 4 using the colored resin composition, the colored film preferably has an average light transmittance of 90% or more, and more preferably 93% or more in the near-infrared region in which the wavelength is 920 nm to 960 nm. By making the colored film have an average light transmittance at a wavelength of 920 nm to 960 nm of 90% or more, the infrared intensity obtained through the colored film can be further improved, and the sensitivity of the near-infrared sensor and the illuminance of the near-infrared camera image can be further improved.

The light transmittance of the colored film can be determined by forming a coating film of the colored resin composition on a transparent substrate, drying the coating film with a hot plate or the like, then heat-treating the dried coating film with a hot air oven or the like to obtain a colored film, and measuring the colored film using an ultraviolet/visible/near-infrared spectrophotometer.

The thickness of the coating film of the colored resin composition is adjusted so that the colored film to be obtained has an OD value of 4. The OD value of the coating film or the colored film can be determined by measuring the intensity of the incident light and the transmitted light of the coating film or the colored film using an optical densitometer (361TVisual; manufactured by X-Rite Inc.), and calculating the OD value from Formula (3) described below. $OD value = {log}_{10} \left({I}_{0}/I\right)$
I₀: Incident light intensity
I: Transmitted light intensity

As the condition of the heat treatment of the coating film, it is preferable that the crosslinkable group included in the resin (A) in the colored resin composition be crosslinked and no crosslinkable group substantially remain in the obtained colored film. For example, in the case that the colored resin composition includes an acrylic resin as the resin (A), the heat treatment temperature is preferably 170°C or more, and the heat treatment time is preferably 30 minutes or more.

As the ultraviolet-visible spectrophotometer, UV-3150 (manufactured by SHIMADZU CORPORATION) is preferably used. The light transmittance of the colored film is measured using the light transmittance of the used transparent substrate as a reference. As the transparent substrate, TEMPAX (manufactured by AGC TECHNO GLASS CO., LTD.) that is a translucent glass substrate is preferable.

Furthermore, when a colored film is formed to have an optical density (OD value) of 2 using the colored resin composition, the colored film preferably has a haze value of 6% or less, and more preferably 3% or less in the visible light region. The haze value is an index of the scattering intensity of the near-infrared transmitted light, and if the haze value is 6% or less, the scattering intensity of the near-infrared transmitted light obtained through the colored film is further suppressed, and the resolution of the near-infrared camera image can be further improved.

The haze of the colored film can be determined by measuring the colored film formed on a transparent substrate in the same manner as in the light transmittance, using a haze meter. As the haze meter, NDH7000 (manufactured by NIPPON DENSHOKU INDUSTRIES CO., LTD.) is preferable.

As the method for producing the colored resin composition used according to the present invention, for example, a method is preferable in which a resin solution containing the resin (A), the colorant (B), and, if necessary, the organic solvent (C) is dispersed using a disperser to prepare a colorant dispersion having a high colorant concentration in advance, furthermore, the resin (A) and, if necessary, another component such as a photosensitizer are added, and the mixture is stirred. If necessary, filtration may be performed.

In the present invention, it is preferable to use a bisbenzofuranone-based pigment having a crystallite size of 10 nm or more and 90 nm or less as the colorant (B). Here, the crystallite size is a value determined from the half width of the main peak appearing at a diffraction angle 2θ of 7.8° or more and 8.0° or less in the X-ray diffraction spectrum using a CuKα ray as an X-ray source. In the production of the colored resin composition, by setting the crystallite size of the bisbenzofuranone-based pigment in the raw material stage to 10 nm or more, the bisbenzofuranone-based pigment is further stably dispersed in the colored resin composition or the colored film, and the crystallite size of the bisbenzofuranone-based pigment in the colored film can be easily set within the desired range described above. Meanwhile, by setting the crystallite size of the bisbenzofuranone-based pigment in the raw material stage to 90 nm or less, the crystallite size of the bisbenzofuranone-based pigment in the colored film can be easily set to 25 nm or less by a general dispersion method.

Examples of the method of setting the crystallite size of the bisbenzofuranone-based pigment within the above-described range include a salt milling treatment in which the bisbenzofuranone-based pigment, an inorganic salt, and an organic solvent are kneaded and ground, and an acid slurry treatment in which the bisbenzofuranone-based pigment is once dissolved in a strong acid such as sulfuric acid and then mixed with a poor solvent.

As the salt milling treatment, a method is preferable in which the bisbenzofuranone-based pigment, a water-soluble inorganic salt, and an organic solvent that does not dissolve the inorganic salt are kneaded, then the kneaded product is put into water, and the resulting slurry is filtered and washed with water to remove the inorganic salt. A resin such as a polymer dispersant and a pigment derivative may be added together with the bisbenzofuranone-based pigment, the water-soluble inorganic salt, and the organic solvent, and the reaggregation of the bisbenzofuranone pigment can be suppressed after the atomization by the salt milling treatment.

Examples of the water-soluble inorganic salt include sodium chloride, potassium chloride, calcium chloride, barium chloride, and sodium sulfate.

The organic solvent is not particularly limited as long as it is water-soluble and does not dissolve the water-soluble inorganic salt. However, during the salt milling, the temperature rises and the organic solvent is in a state of being easily evaporated, therefore a high boiling point solvent is preferable from the viewpoint of safety. Examples of the organic solvent include 2-methoxyethanol, 2-butoxyethanol, 2-(isopentyloxy)ethanol, 2-(hexyloxy)ethanol, diethylene glycol, diethylene glycol monomethyl ether, diethylene glycol monoethyl glycol, diethylene glycol monobutyl ether, triethylene glycol, triethylene glycol monomethyl ether, liquid polyethylene glycol, 1-methoxy-2-propanol, 1-ethoxy-2-propanol, dipropylene glycol, dipropylene glycol monomethyl ether, dipropylene glycol monoethyl ether, and low molecular weight polypropylene glycol. Two or more of these organic solvents may be used.

Examples of the kneading device include "Trimix" (registered trademark) that is a kneader, mix muller, and planetary mixer manufactured by INOUE MFG., INC., and "Miracle KCK" (registered trademark) that is a continuous single-screw kneader manufactured by ASADA IRON WORKS. CO., LTD.

The bisbenzofuranone-based pigment in the raw material stage preferably has a specific surface area of 10 m²/g or more and 100 m²/g or less, and more preferably 40 m²/g or more and 100 m²/g or less. By setting the specific surface area of the bisbenzofuranone-based pigment to 10 m²/g or more, the bisbenzofuranone-based pigment is easily finely dispersed, and the dispersion stability in the colored resin composition can be improved. Meanwhile, by setting the specific surface area of the bisbenzofuranone-based pigment to 100 m²/g or less, the reaggregation of the bisbenzofuranone-based pigment is suppressed, and the dispersion stability in the colored resin composition and the visible light shielding property of the colored film can be further improved. Here, the specific surface area of the bisbenzofuranone-based pigment can be determined by a BET multipoint method based on a nitrogen gas adsorption method using a gas adsorption specific surface area measuring device. Examples of the method of setting the specific surface area within the above-described range include the salt milling treatment and the acid slurry treatment described above.

Examples of the disperser to disperse the resin solution containing the resin (A), the colorant (B), and, if necessary, the organic solvent (C) include ball mills, bead mills, sand grinders, three roll mills, and high-speed impact mills. Among these dispersers, the bead mills are preferable for the efficient dispersion and the fine dispersion. Examples of the bead mills include coball mills, basket mills, pin mills, and dyno mills. Examples of the bead in the bead mill include a titania bead, a zirconia bead, and a zircon bead.

The dispersion is preferably performed using a bead mill in multiple stages, and a step is preferably included in which a dispersion treatment is performed with a bead mill in which a bead having an average bead diameter of more than 0.1 mmφ is used, and then a dispersion treatment is performed with a bead mill in which a bead having an average bead diameter of 0.1 mmφ or less is used. By the dispersion treatment with a bead mill in which a bead having an average bead diameter of more than 0.1 mmφ is used, the bisbenzofuranone-based pigment having a large crystallite size can be efficiently disintegrated. By the subsequent dispersion treatment with a bead mill in which a fine bead having an average bead diameter of 0.1 mmφ or less is used, the energy to be provided to the bisbenzofuranone-based pigment is reduced to finely disperse the bisbenzofuranone-based pigment while the surface activity of the bisbenzofuranone-based pigment is suppressed, the reaggregation of the bisbenzofuranone-based pigment in the colored resin composition is suppressed, and the bisbenzofuranone-based pigment can be further uniformly dispersed. In this case, the bead mill is preferably provided with a centrifugal separator capable of separating the fine bead from the dispersion. Here, the word "average bead diameter" refers to the number average value of the equivalent circle diameters of the beads. Specifically, the beads are magnified 45 times and photographed with a stereomicroscope, and the longest diameter and the shortest diameter of each of 100 randomly selected beads are measured and the average value of the longest diameter and the shortest diameter is regarded as the equivalent circle diameter, and the number average value of the equivalent circle diameters are calculated to determine the bead diameter.

The colored film can be produced by curing the colored resin composition used according to the present invention. The colored film preferably has an average light transmittance of 90% or more, and more preferably 93% or more in the near-infrared region in which the wavelength per an OD value of 4 is 920 nm to 960 nm. The average light transmittance can be measured as described above. Here, the average light transmittance of the colored film per an OD value of 4 means the average light transmittance of the colored film having a thickness at which the OD value of the colored film is 4. Because the OD value is proportional to the thickness of the colored film, the thickness at which the OD value of the colored film is 4 can be calculated from the measured OD value and thickness of the colored film. Meanwhile, the light transmittance T is in the relationship shown in the following formula with the absorbance A, and the absorbance A is proportional to the film thickness, therefore, the average light transmittance of the colored film having a thickness at which the OD value of the colored film is 4 can be calculated. $T = {10}^{- A}$

Furthermore, the haze value in the visible light region per an OD value of 2 is preferably 6% or less, and more preferably 3% or less. The haze can be measured as described above. Here, the haze value of the colored film per an OD value of 2 means the haze value of the colored film having a thickness at which the OD value of the colored film is 2. Because the haze is also proportional to the film thickness, the haze at an OD value of 2 can be calculated in the same manner as described above.

Furthermore, the refractive index of the colored film with respect to light having a wavelength of 940 nm is preferably 1.40 or more and 1.60 or less, and more preferably 1.50 or more and 1.60 or less. The colored film can be produced by applying the colored resin composition to a substrate and curing the colored resin composition. By reducing the refractive index difference between the colored film and the substrate, the infrared transmittance of the colored film can be improved.

The refractive index of the colored film can be determined by analyzing the reflected light of the colored film using ellipsometry or a spectral reflectance method.

Next, a method of curing the colored resin composition used according to the present invention to form a colored film will be described with reference to an example of a negative photosensitive colored resin composition.

The photosensitive colored resin composition is applied to a substrate to obtain a coating film. Examples of the substrate include transparent substrates including soda glass, non-alkali glass, quartz glass, or the like; and substrates including a silicon wafer, a ceramic, gallium arsenide, or the like. Examples of the application method include spin application using a spinner, spray application, ink-jet application, die coating, and roll coating. The thickness of the coating film can be appropriately selected depending on the application method and the like. The thickness after drying is generally 1 to 150 µm.

The obtained coating film is dried to obtain a dry film. Examples of the drying method include drying by heating, air drying, drying under reduced pressure, and infrared irradiation. Examples of the apparatus for drying by heating include ovens and hot plates. The drying temperature is preferably 50 to 150°C, and the drying time is preferably 1 minute to several hours.

The obtained dry film is irradiated with an actinic ray through a mask having a desired pattern to obtain an exposed film. Examples of the actinic ray for the irradiation include ultraviolet rays, visible rays, electron rays, and X-rays. The colored resin composition used according to the present invention is preferably irradiated with i-line (365 nm), h-line (405 nm), or g-line (436 nm) of a mercury lamp.

The obtained exposed film is developed using an alkaline developing solution or the like to remove an unexposed portion and obtain a pattern. Examples of the alkaline compound used in the alkaline developing solution include inorganic alkalis such as sodium hydroxide, potassium hydroxide, sodium carbonate, potassium carbonate, sodium silicate, sodium metasilicate, and aqueous ammonia; primary amines such as ethylamine and n-propylamine; secondary amines such as diethylamine and di-n-propylamine; tertiary amines such as triethylamine and methyldiethylamine; tetraalkylammonium hydroxides such as tetramethylammonium hydroxide (TMAH); quaternary ammonium salts such as choline; alcoholamines such as triethanolamine, diethanolamine, monoethanolamine, dimethylaminoethanol, and diethylaminoethanol; and organic alkalis such as cyclic amines such as pyrrole, piperidine, 1,8-diazabicyclo[5,4,0]-7-undecene, 1,5-diazabicyclo[4,3,0]-5-nonane, and morpholine.

The concentration of the alkaline compound in the alkaline developing solution is generally 0.01 to 50% by weight, and preferably 0.02 to 1% by weight. In order to improve the shape of the pattern obtained by the development, 0.1 to 5% by weight of a surfactant such as a nonionic surfactant may be added to the developing solution. Furthermore, in the case that the developing solution is an alkaline aqueous solution, a water-soluble organic solvent such as ethanol, γ-butyrolactone, dimethylformamide, or N-methyl-2-pyrrolidone may be added to the developing solution.

Examples of the developing method include an immersion method, a spray method, and a paddle method. Furthermore, the obtained pattern may be rinsed with pure water or the like.

By subjecting the obtained pattern to a heat treatment (post-bake), a patterned colored film can be produced. The heat treatment may be performed in air, in a nitrogen atmosphere, or in a vacuum state. The heating temperature is preferably 150 to 300°C, and the heating time is preferably 0.25 to 5 hours. The heating temperature may be changed continuously or may be changed stepwise.

The colored resin composition and the colored film used according to the present invention have high near-infrared transmissivity and low visible light transmissivity, and therefore, are used according to the present invention in a colored film to hide a near-infrared sensor or a near-infrared camera from the outside (hereinafter, referred to as a near-infrared transmission light shielding film, or simply referred to as a light shielding film). In the above-described application, a decorative substrate in which the light shielding film is formed on a transparent substrate is often used. According to the present invention, the colored resin composition and the colored film can used in a light shielding film on a decorative substrate in a display terminal such as a smartphone or a tablet PC, a light shielding film on a decorative substrate for a decorative panel to hide a near-infrared sensor or a near-infrared camera for driver monitoring or for a gesture sensor mounted on an in-vehicle display or an in-vehicle instrument, a light shielding film such as a black matrix of a color filter included in a liquid crystal display device, a colored partition inside an organic EL display, or the like.

### EXAMPLES

Hereinafter, the present invention will be described in detail with reference to Examples and Comparative Examples, but the present invention is not limited to these aspects.

### <Evaluation Method>

### [Crystallite Size of Bisbenzofuran-Based Pigment]

As a measurement sample of the crystallite size of the bisbenzofuranone-based pigment in the raw material stage, the benzofuran-based pigment Bk-1 used in Production Examples described below and Bk-2 obtained in Production Example 1 were each packed in an aluminum standard sample holder. Furthermore, as a measurement sample of the crystallite size of the bisbenzofuranone-based pigment in the colored film, the colored film obtained in Examples and Comparative Examples was cut out from the glass substrate and packed in an aluminum standard sample holder. The X-ray diffraction spectrum of each of the measurement samples was measured by wide-angle X-ray diffraction with an X-ray diffractometer DS ADVANCE (trade name) manufactured by Bruker AXS GmbH using a CuKα ray as an X-ray source. The measurement conditions were as follows. The output was 40 kV/40 mA, the slit system was Div. Slit: 0.3°, the measurement step (2θ) was 0.0171°, and the measurement time was 0.5 sec/step.

The diffraction angle and the half width of the main peak derived from the benzofuran-based pigment observed in the vicinity of a diffraction angle 2θ of 7.9° was measured, and the crystallite size in the particle was determined using the Scherrer equation shown in Formula (1) described above.

### [Specific Surface Area]

The benzofuran-based pigment Bk-1 used in Production Examples described below and Bk-2 obtained in Production Example 1 were each vacuum-degassed at 100°C using a high precision fully automatic gas adsorption device "BELSORP" 36 manufactured by BEL Japan, Inc., then the adsorption isotherm of an N₂ gas at a liquid nitrogen temperature (77K) was measured, and the isotherm was analyzed by the BET method to determine the specific surface area.

### [Light Shielding Property]

The OD value per a thickness of 1 µm of the colored film obtained in each of Examples and Comparative Examples was calculated using an optical densitometer 361TVisual manufactured by X-Rite Inc.

### [Visible Light Shielding Property and Near-Infrared Transmissivity]

The light transmittance of the colored film that was obtained in each of Examples and Comparative Examples and had a film thickness at which the OD value was 4 was measured using an ultraviolet-visible spectrophotometer UV-3150 manufactured by SHIMADZU CORPORATION at a wavelength from 400 nm to 700 nm to determine the maximum transmittance. The lower the maximum transmittance is, the more excellent the light shielding property in the visible light region is. Furthermore, the light transmittance of the colored film that was obtained in each of Examples and Comparative Examples and had a film thickness at which the OD value was 4 was measured in the same manner at a wavelength from 920 nm to 960 nm to determine the average transmittance. The higher the average transmittance is, the more excellent the light transmittance in the near-infrared region is.

### [Transmitted Light Scattering]

The haze value of the colored film that was obtained in each of Examples and Comparative Examples and had a film thickness at which the OD value was 2 was measured using a haze meter NDH7000 (trade name) manufactured by NIPPON DENSHOKU INDUSTRIES CO., LTD. The smaller the haze value is, the more the scattering of transmitted light is suppressed.

### [Refractive Index]

The refractive index of the colored film obtained in each of Examples and Comparative Examples with respect to light having a wavelength of 940 nm was measured with a high-speed spectroscopic ellipsometer (M-2000, manufactured by J. A. Woollam Co. Inc.) at an incident angle of 50°, 60° and 70° using WVASE32 as analysis software. The smaller the refractive index is, the higher the near-infrared transmittance is.

### [Near-Infrared Camera Image]

An infrared camera module Freemo manufactured by Alpha Technology Co., Ltd. was placed on the back surface of the colored film obtained in each of Examples and Comparative Examples, and the obtained camera image was evaluated in accordance with the following criteria.
A: Clear image can be confirmed
B: Image can be confirmed, but outline is unclear
C: Image cannot be confirmed

### [Light Resistance]

The discoloration of the colored film obtained in each of Examples and Comparative Examples was visually observed after being irradiated with an ultraviolet ray for 300 hours using Q-SUN xenon tester Xe-3 manufactured by Q-Lab Corporation with an Xe lamp X-1800 as a light source at an intensity at which the illuminance at a wavelength of 420 nm was 1.2 W/m², and the presence or absence of fading was evaluated.

### (Synthesis Example 1 Synthesis of Acrylic Resin (P-1))

A methyl methacrylate/methacrylic acid/styrene copolymer (weight ratio: 30/40/30) was synthesized by the method described in Example 1 of Japanese Patent No. 3120476. To 100 parts by weight of the obtained copolymer, 40 parts by weight of glycidyl methacrylate was added. The product was reprecipitated with purified water, filtered out, and dried to obtain an alkali-soluble acrylic resin (P-1) having a weight average molecular weight of 15,000 and an acid value of 110 mg KOH/g. The acid value of the acrylic resin was the amount (mg) of potassium hydroxide required to neutralize 1 g of the acrylic resin (unit: mg KOH/g), and the weight average molecular weight was measured in terms of polystyrene using gel permeation chromatography (GPC) "HLC-8220GPC" (a test device manufactured by Tosoh Corporation) with tetrahydrofuran as a carrier.

### (Production Example 1 Production of Bisbenzofuran-Based Pigment Bk-2)

As the bisbenzofuran-based pigment being a raw material for a fine particle, "Irgaphor" Black S0100CF (Bk-1) manufactured by BASF SE was prepared. The specific surface area of Bk-1 measured by the above-described method was 4 m²/g. Furthermore, Bk-1 was measured by the above-described method to determine the half width of the main peak at 2θ = 7.90°, and the result was 0.145°. The crystallite size calculated from this value was 124 nm.

Into a kneader (Model S KNEADER (trade name) manufactured by Moriyama Works), 200 g of the above-described Bk-1, 2,400 g of sodium chloride, and 400 g of diethylene glycol were put, and kneaded at 70°C for 8 hours. Next, the resulting kneaded product was put into about 10 L of warm water, and the mixture was stirred with a high-speed mixer for 1 hour while heated at 40°C and formed into slurry. Then, the slurry was filtered, washed with water to remove the sodium chloride and the diethylene glycol, and vacuum-dried at 80°C for 24 hours to obtain a bisbenzofuran-based pigment Bk-2. The specific surface area of the obtained Bk-2 measured by the above-described method was 66 m²/g. Furthermore, Bk-2 was measured by the above-described method to determine the half width of the main peak at 2θ = 7.90°, and the result was 0.261°. The crystallite size calculated from this value was 42 nm.

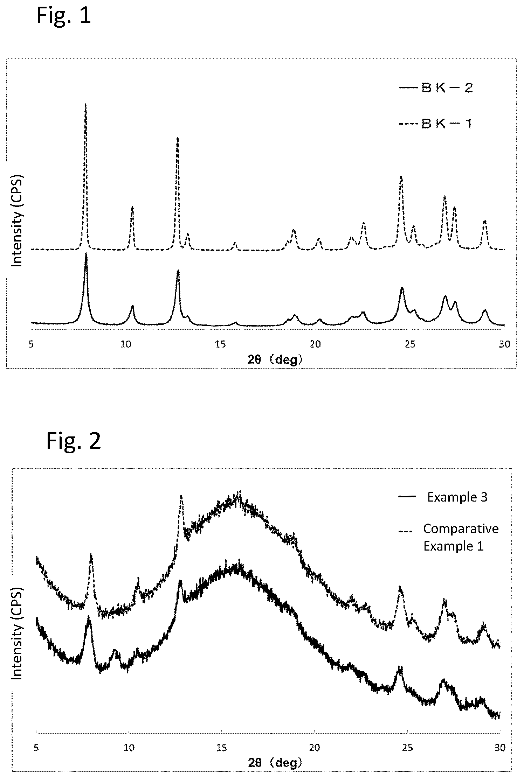

Table 1 shows the evaluation results of Bk-1 and Bk-2 obtained by making a fine particle of Bk-1. Fig. 1 shows the X-ray diffraction profile.

**[Table 1]**

| | | X-ray diffraction spectrum | | | Specific surface area (m²/g) |
|---|---|---|---|---|---|
| | | Diffraction angle of main peak 2θ (°) | Half width of main peak (°) | Crystallite size (nm) | |
| Colorant 1 | Benzofuranone-based pigment Bk-1 | 7.89 | 0.145 | 124 | 4 |
| Colorant 2 | Benzofuranone-based pigment Bk-2 | 7.90 | 0.261 | 42 | 66 |

### (Production Example 2 Production of Colorant Dispersion (DP-1))

Into a tank, 120 g of the bisbenzofuranone-based pigment Bk-1, 171 g of a 35% by weight propylene glycol monomethyl ether acetate (PGMEA) solution of the acrylic polymer (P-1) obtained in Synthesis Example 1, 20 g of a polyamide-based polymer dispersant "DISPERBYK" (registered trademark) 2200 (BYK-2200) as a polymer dispersant, and 689 g of PGMEA were put, and the mixture was stirred with a homomixer for 20 minutes to obtain a preliminary dispersion. The obtained preliminary dispersion was supplied to a disperser Ultra Apex Mill UAM015 manufactured by Kotobuki Industries Co., Ltd. equipped with a centrifugal separator filled with 75% by volume of a zirconia bead having a bead diameter of 0.30 mmφ, and dispersed for 20 minutes at a rotational speed of 12 m/s. Subsequently, the liquid after the dispersion was supplied to Ultra Apex Mill UAM015 filled with 75% by volume of a zirconia bead having a bead diameter of 0.05 mmφ, and dispersed for 90 minutes at a rotational speed of 8 m/s to obtain a colorant dispersion DP-1 having a solid content concentration of 20% by weight and a ratio of colorant/(resin + polymer dispersant) (weight ratio) of 60/40.

### (Production Example 3 Production of Colorant Dispersion (DP-2))

A preliminary dispersion was obtained in the same manner as in Production Example 2 except that the bisbenzofuranone-based pigment Bk-2 obtained in Production Example 1 was used instead of the bisbenzofuranone-based pigment Bk-1. The obtained preliminary dispersion was supplied to a disperser Ultra Apex Mill UAM015 manufactured by Kotobuki Industries Co., Ltd. equipped with a centrifugal separator filled with 75% by volume of a zirconia bead having a bead diameter of 0.10 mmφ, and dispersed for 90 minutes at a rotational speed of 8 m/s to obtain a colorant dispersion DP-2 having a solid content concentration of 20% by weight and a ratio of colorant/(resin + polymer dispersant) (weight ratio) of 60/40.

### (Production Example 4 Production of Colorant Dispersion (DP-3))

A colorant dispersion (DP-3) was obtained by dispersion in multiple stages in the same manner as in Production Example 2 except that the bisbenzofuranone-based pigment Bk-2 obtained in Production Example 1 was used instead of the bisbenzofuranone-based pigment Bk-1.

### (Production Example 5 Production of Colorant Dispersion (DP-4))

A colorant dispersion (DP-4) was obtained in the same manner as in Production Example 4 except that an acrylic-based polymer dispersant "DISPERBYK" (registered trademark) -LP N21116 (amine value = 32 mg KOH/g) was used instead of "DISPERBYK" (registered trademark) 2200 as the polymer dispersant.

### (Production Example 6 Production of Colorant Dispersion (DP-5))

A colorant dispersion (DP-5) was obtained in the same manner as in Production Example 3 except that Bk-1 was used as the benzofuranone-based pigment, "DISPERBYK" (registered trademark) -LP N21116 was used as the polymer dispersant, and a zirconia bead having a bead diameter of 0.30 mmφ was used as the dispersion bead.

### (Production Example 7 Production of Colorant Dispersion (DP-6))

A colorant dispersion (DP-6) was obtained in the same manner as in Production Example 6 except that a zirconia bead having a bead diameter of 0.10 mmφ was used as the dispersion bead.

### (Production Example 8 Production of Colorant Dispersion (DP-7))

A colorant dispersion (DP-7) was obtained in the same manner as in Production Example 7 except that a blue pigment (copper phthalocyanine) PB15:6 (manufactured by TOYO INK CO., LTD.) was used as the colorant.

### (Production Example 9 Production of Colorant Dispersion (DP-8))

A colorant dispersion (DP-8) was obtained in the same manner as in Production Example 7 except that a carbon black (TPK1227 manufactured by Cabot Corporation) whose surface was modified with a sulfonic acid group was used as the colorant.

### (Production Example 10 Production of Colorant Dispersion (DP-9))

Into a tank, 120 g of a black dye OIL Black 860 (manufactured by ORIENT CHEMICAL INDUSTRIES CO., LTD.) as a colorant, 229 g of a 35 % by weight propylene glycol monomethyl ether acetate (PGMEA) solution of the acrylic polymer (P-1), and 651 g of PGMEA were put, the mixture was stirred with a homomixer for 20 minutes to dissolve the dye, and a colorant dispersion (DP-9) having a solid content concentration of 20% by weight and a ratio of colorant/resin (weight ratio) of 60/40 was obtained.

Table 2 shows the compositions and dispersion conditions in Production Examples 2 to 10.

**[Table 2]**

| | | Resin (A) | Colorant (B) | Organic solvent (C) | Polymer dispersant | Dispersion condition | | | | | |
|---|---|---|---|---|---|---|---|---|---|---|---|
| | | | | | | Bead diameter (1) | Rotational speed (1) | Dispersion time (1) | Bead diameter (2) | Rotational speed (2) | Dispersion time (2) |
| Colorant dispersion 1 | DP-1 | P-1 | Bisbenzofuranone-based pigment Bk-1 | PGMEA | BYK-2200 | 0.30 mmφ | 12 m/s | 20 minutes | 0.05 mmφ | 8 m/s | 90 minutes |
| Colorant dispersion 2 | DP-2 | P-1 | Bisbenzofuranone-based pigment Bk-2 | PGMEA | BYK-2200 | 0.10 mmφ | 8 m/s | 90 minutes | - | - | - |
| Colorant dispersion 3 | DP-3 | P-1 | Bisbenzofuranone-based pigment Bk-2 | PGMEA | BYK-2200 | 0.30 mmφ | 12 m/s | 20 minutes | 0.05 mmφ | 8 m/s | 90 minutes |
| Colorant dispersion 4 | DP-4 | P-1 | Bisbenzofuranone-based pigment Bk-2 | PGMEA | LPN21116 | 0.30 mmφ | 12 m/s | 20 minutes | 0.05 mmφ | 8 m/s | 90 minutes |
| Colorant dispersion 5 | DP-5 | P-1 | Bisbenzofuranone-based pigment Bk-1 | PGMEA | LPN21116 | 0.30 mmφ | 8 m/s | 90 minutes | - | - | - |
| Colorant dispersion 6 | DP-6 | P-1 | Bisbenzofuranone-based pigment Bk-1 | PGMEA | LPN21116 | 0.10 mmφ | 8 m/s | 90 minutes | - | - | - |
| Colorant dispersion 7 | DP-7 | P-1 | Blue pigment PB15:6 | PGMEA | LPN21116 | 0.10 mmφ | 8 m/s | 90 minutes | - | - | - |
| Colorant dispersion 8 | DP-8 | P-1 | Carbon black CB-1 | PGMEA | LPN21116 | 0.10 mmφ | 8 m/s | 90 minutes | - | - | - |
| Colorant dispersion 9 | DP-9 | P-1 | Dye | PGMEA | - | - | - | - | - | - | - |

### (Example 1)

In 27.08 g of a colorant dispersion (DP-1), 29.83 g of a 35% by weight PGMEA solution of an acrylic polymer (P-1), 8.74 g of dipentaerythritol hexaacrylate (manufactured by Nippon Kayaku Co., Ltd.) as a polyfunctional monomer, 0.4 g of KBM5103 (manufactured by Shin-Etsu Chemical Co., Ltd.) as an adhesion improving agent, and a solution as a surfactant produced by dissolving 0.3 g of a 10% by weight PGMEA solution of a silicone-based surfactant "BYK" 333 (manufactured by BYK-Chemie GmbH) in 33.65 g of PGMEA were added to obtain a colored resin composition PC-1 having a total solid content concentration of 25% by weight and a content of the colorant in the total solid content of 13% by weight.

The obtained colored resin composition PC-1 was applied to a non-alkali glass substrate (AN100) using a spinner (1H-DS) manufactured by MIKASA CO., LTD., and the resulting coating film was heat-dried on a hot plate at 100°C for 2 minutes to obtain a dry film. The dry film was post-baked in a hot air oven at 230°C for 30 minutes to obtain a colored film C-1. Two kinds of substrates having different film thicknesses so that the colored film C-1 had an OD value of 2 in one of the substrates and 4 in the other were prepared, the substrate in which the colored film C-1 had an OD value of 4 was used to evaluate the light shielding property, and the substrate in which the colored film C-1 had an OD value of 2 was used to evaluate the haze value. Table 3 shows the results of evaluating the colored film C-1 by the method described above.

### (Example 2)

A colored resin composition PC-2 was obtained in the same manner as in Example 1 except that a colorant dispersion (DP-2) was used instead of the colorant dispersion (DP-1). The obtained colored resin composition PC-2 was used to evaluate in the same manner as in Example 1. The results are shown in Table 3.

### (Example 3)

A colored resin composition PC-3 was obtained in the same manner as in Example 1 except that a colorant dispersion (DP-3) was used instead of the colorant dispersion (DP-1). The obtained colored resin composition PC-3 was used to evaluate in the same manner as in Example 1. The results are shown in Table 3. Fig. 2 shows the X-ray diffraction profile of the colored film.

### (Example 4)

A colored resin composition PC-4 was obtained in the same manner as in Example 1 except that a colorant dispersion (DP-4) was used instead of the colorant dispersion (DP-1). The obtained colored resin composition PC-4 was used to evaluate in the same manner as in Example 1. The results are shown in Table 3.

### (Example 5)

In 10.42 g of a colorant dispersion (DP-3), 36.56 g of a 35% by weight PGMEA solution of an acrylic polymer (P-1), 9.72 g of dipentaerythritol hexaacrylate (manufactured by Nippon Kayaku Co., Ltd.) as a polyfunctional monomer, 0.4 g of KBM5103 (manufactured by Shin-Etsu Chemical Co., Ltd.) as an adhesion improving agent, and a solution as a surfactant produced by dissolving 0.3 g of a 10% by weight PGMEA solution of a silicone-based surfactant "BYK" 333 (manufactured by BYK-Chemie GmbH) in 42.61 g of PGMEA were added to obtain a colored resin composition PC-5 having a total solid content concentration of 25% by weight and a content of the colorant in the total solid content of 5% by weight. The obtained colored resin composition PC-5 was used to evaluate in the same manner as in Example 1. The results are shown in Table 3.

### (Example 6)

In 52.08 g of a colorant dispersion (DP-3), 19.75 g of a 35% by weight PGMEA solution of an acrylic polymer (P-1), 7.27 g of dipentaerythritol hexaacrylate (manufactured by Nippon Kayaku Co., Ltd.) as a polyfunctional monomer, 0.4 g of KBM5103 (manufactured by Shin-Etsu Chemical Co., Ltd.) as an adhesion improving agent, and a solution as a surfactant produced by dissolving 0.3 g of a 10% by weight PGMEA solution of a silicone-based surfactant "BYK" 333 (manufactured by BYK-Chemie GmbH) in 20.20 g of PGMEA were added to obtain a colored resin composition PC-6 having a total solid content concentration of 25% by weight and a content of the colorant in the total solid content of 25% by weight. The obtained colored resin composition PC-6 was used to evaluate in the same manner as in Example 1. The results are shown in Table 3.

### (Example 7)

In a mixed solution of 21.67 g of a colorant dispersion (DP-3) and 5.42 g of a blue colorant dispersion (DP-7), 29.83 g of a 35% by weight PGMEA solution of an acrylic polymer (P-1), 8.74 g of dipentaerythritol hexaacrylate (manufactured by Nippon Kayaku Co., Ltd.) as a polyfunctional monomer, 0.4 g of KBM5103 (manufactured by Shin-Etsu Chemical Co., Ltd.) as an adhesion improving agent, and a solution as a surfactant produced by dissolving 0.3 g of a 10% by weight PGMEA solution of a silicone-based surfactant "BYK" 333 (manufactured by BYK-Chemie GmbH) in 33.65 g of PGMEA were added to obtain a colored resin composition PC-7 having a total solid content concentration of 25% by weight and a content of the colorant in the total solid content of 13% by weight. The obtained colored resin composition PC-7 was used to evaluate in the same manner as in Example 1. The results are shown in Table 3.

### (Example 8)

A colored resin composition PC-8 having a total solid content concentration of 25% by weight and a content of the colorant in the total solid content of 13% by weight was obtained in the same manner as in Example 7 except that a mixed solution of 16.25 g of a colorant dispersion (DP-3) and 10.83 g of a blue colorant dispersion (DP-7) was used as the colored dispersion. The obtained colored resin composition PC-8 was used to evaluate in the same manner as in Example 1. The results are shown in Table 3.

### (Example 9)

A colored resin composition PC-9 having a total solid content concentration of 25% by weight and a content of the colorant in the total solid content of 13% by weight was obtained in the same manner as in Example 3 except that 0.41 g of "ADEKA ARKLS" (registered trademark) NCI-831 (manufactured by ADEKA Corporation) was added as a photopolymerization initiator. The obtained colored resin composition PC-9 was applied to a non-alkali glass substrate (AN100) using a spinner (1H-DS) manufactured by MIKASA CO., LTD., and the resulting coating film was heat-dried on a hot plate at 100°C for 2 minutes. The entire surface of the resulting dry film was exposed to an ultraviolet ray with an exposure amount of 100 mJ/cm² using a mask aligner (PEM-6M) manufactured by Union Optical Co., Ltd., and then the dry film was post-baked in a hot air oven at 230°C for 30 minutes to obtain a colored film C-9. The colored film C-9 was evaluated in the same manner as in Example 1. The results are shown in Table 3.

### (Comparative Example 1)

A colored resin composition PC-10 was obtained in the same manner as in Example 1 except that a colorant dispersion (DP-5) was used instead of the colorant dispersion (DP-1). The obtained colored resin composition PC-10 was used to evaluate in the same manner as in Example 1. The results are shown in Table 3. Fig. 2 shows the X-ray diffraction profile of the colored film.

### (Comparative Example 2)

A colored resin composition PC-11 was obtained in the same manner as in Example 1 except that a colorant dispersion (DP-6) was used instead of the colorant dispersion (DP-1). The obtained colored resin composition PC-11 was used to evaluate in the same manner as in Example 1. The results are shown in Table 3.

### (Comparative Example 3)

A colored resin composition PC-12 was obtained in the same manner as in Example 1 except that a colorant dispersion (DP-8) was used instead of the colorant dispersion (DP-1). The obtained colored resin composition PC-12 was used to evaluate in the same manner as in Example 1. The results are shown in Table 3.

### (Comparative Example 4)

A colored resin composition PC-13 was obtained in the same manner as in Example 1 except that a colorant dispersion (DP-9) was used instead of the colorant dispersion (DP-1). The obtained colored resin composition PC-13 was used to evaluate in the same manner as in Example 1. The results are shown in Table 3.

**[Table 3-1]**

| | Colored resin composition | Colored resin composition | | | |
|---|---|---|---|---|---|
| | | Resin (A) | Colorant dispersion | Organic solvent (C) | Content of colorant (B) ^{*1} |
| Example 1 | PC-1 | P-1 | DP-1 | PGMEA | 13% by weight |
| Example 2 | PC-2 | P-1 | DP-2 | PGMEA | 13% by weight |
| Example 3 | PC-3 | P-1 | DP-3 | PGMEA | 13% by weight |
| Example 4 | PC-4 | P-1 | DP-4 | PGMEA | 13% by weight |
| Example 5 | PC-5 | P-1 | DP-3 | PGMEA | 5% by weight |
| Example 6 | PC-6 | P-1 | DP-3 | PGMEA | 25% by weight |
| Example 7 | PC-7 | P-1 | DP-3:DP-7 = 80:20 | PGMEA | 13% by weight |
| Example 8 | PC-8 | P-1 | DP-3:DP-7 = 60: 40 | PGMEA | 13% by weight |
| Example 9 | PC-9 | P-1 | DP-3 | PGMEA | 13% by weight |
| Comparative Example 1 | PC-10 | P-1 | DP-5 | PGMEA | 13% by weight |
| Comparative Example 2 | PC-11 | P-1 | DP-6 | PGMEA | 13% by weight |
| Comparative Example 3 | PC-12 | P-1 | DP-8 | PGMEA | 13% by weight |
| Comparative Example 4 | PC-13 | P-1 | DP-9 | PGMEA | 13% by weight |

| | | | | | |
|---|---|---|---|---|---|
| *1: % by weight in 100% by weight of total solid content *2: Film thickness at which OD value is 4.0 | | | | | |

**[Table 3-2]**

| | Colored resin composition | Result of evaluating colored film | | | | | | | | |
|---|---|---|---|---|---|---|---|---|---|---|
| | | Crystallite size | Light shielding property OD value | Film thickness ^{*2} (µm) | Visible light shielding property (Maximum transmittance) | Near-infrared transmissivity (Average transmittance) | Transmitted light scattering haze value (OD = 2.0) | Refractive index (940 nm) | Near-infrared camera image | Light resistance |
| Example 1 | PC-1 | 21 nm | 4.0 | 8.0 | 10% | 89% | 3.5% | 1.57 | A | No fading |
| Example 2 | PC-2 | 18 nm | 4.0 | 8.0 | 11% | 92% | 1.1% | 1.57 | A | No fading |
| Example 3 | PC-3 | 16 nm | 4.0 | 8.0 | 12% | 95% | 1.1% | 1.57 | A | No fading |
| Example 4 | PC-4 | 17 nm | 4.0 | 8.0 | 11% | 93% | 1.6% | 1.57 | A | No fading |
| Example 5 | PC-5 | 16 nm | 4.0 | 20.0 | 12% | 97% | 0.8% | 1.54 | A | No fading |
| Example 6 | PC-6 | 16 nm | 4.0 | 4.0 | 12% | 94% | 1.6% | 1.64 | A | No fading |
| Example 7 | PC-7 | 16 nm | 4.0 | 7.8 | 2% | 94% | 1.3% | 1.59 | A | No fading |
| Example 8 | PC-8 | 16 nm | 4.0 | 7.5 | 0.5% | 93% | 1.5% | 1.61 | A | No fading |
| Example 9 | PC-9 | 16 nm | 4.0 | 8.0 | 12% | 94% | 1.3% | 1.58 | A | No fading |
| Comparative Example 1 | PC-10 | 30 nm | 4.0 | 8.0 | 8% | 81% | 14.0% | 1,57 | B | No fading |
| Comparative Example 2 | PC-11 | 28 nm | 4.0 | 8.0 | 9% | 84% | 10.0% | 1.57 | B | No fading |
| Comparative Example 3 | PC-12 | - | 4.0 | 4.0 | 0.2% | 0.3% | 5.5% | - | C | No fading |
| Comparative Example 4 | PC-13 | - | 4.0 | 8.0 | 3% | 98% | 0.1% | - | A | Fading is present |

| | | | | | | | | | | |
|---|---|---|---|---|---|---|---|---|---|---|
| *1: % by weight in 100% by weight of total solid content *2: Film thickness at which OD value is 4.0 | | | | | | | | | | |

It can be seen that the colored resin composition in each of Examples has low maximum transmittance in the visible light region, high average transmittance in the near-infrared region, and low haze. Meanwhile, the colored resin composition in each of Comparative Examples 1 and 2 had low average transmittance in the near-infrared region and high haze, and the obtained near-infrared camera image was unclear. In Comparative Example 3, no near-infrared camera image was obtained, and in Comparative Example 4, fading was observed after the light resistance test.

### INDUSTRIAL APPLICABILITY

The colored resin composition is used as a black decorative ink that forms a near-infrared transmission light shielding film according to the present invention, which is suitable for hiding a near-infrared camera or sensor.

## Claims

1. A near-infrared transmission light shielding film comprising a cured product of the colored resin composition, wherein the colored resin composition comprises:
a resin (A);
a colorant (B); and
an organic solvent (C), the colored resin composition including at least a bisbenzofuranone-based pigment as the colorant (B), which has a structure represented by any one of General Formulae (I) to (III) described below: 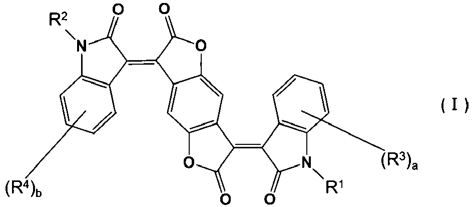 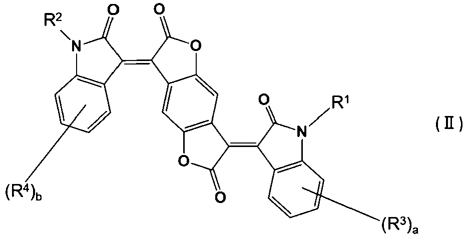 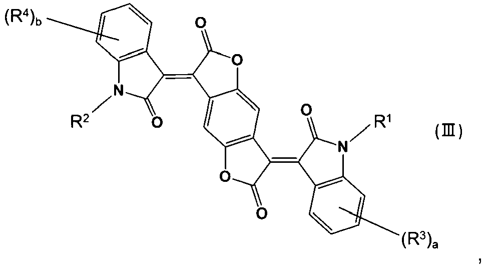
wherein in general Formulae (1) to (III),
- R¹ and R² each independently represent a hydrogen atom or an alkyl group having 1 to 10 carbon atoms,
- R³ and R⁴ each independently represent R¹⁰, OR¹¹, SR¹¹, COR¹¹, CONR¹¹R¹², NR¹¹COR¹², OCOR¹¹, COOR¹¹, SCOR¹¹, OCSR¹¹, COSR¹¹, CSOR¹¹, CN, a halogen atom, or a hydroxyl group, wherein R¹⁰ represents an alkyl group having 1 to 20 carbon atoms, an aryl group having 6 to 30 carbon atoms, an arylalkyl group having 7 to 30 carbon atoms, or a heterocyclic group having 2 to 20 carbon atoms, R¹¹ and R¹² each independently represent a hydrogen atom, an alkyl group having 1 to 20 carbon atoms, an aryl group having 6 to 30 carbon atoms, an arylalkyl group having 7 to 30 carbon atoms, or a heterocyclic group having 2 to 20 carbon atoms, and
- a and b each independently represent an integer of 0 to 4.
wherein the bisbenzofuranone-based pigment has a crystallite size of 10 nm or more and 25 nm or less in a colored film consisting of a cured product of the colored resin composition,
wherein the colorant (B) is included at a content of 1 to 17% by weight based on a total solid content,
wherein the crystallite size of the bisbenzofuran-based pigment is determined as follows: the main peak having the highest intensity is observed at a diffraction angle 2θ of 7.8° or more and 8.0° or less using a CuKa ray as an Xray source. From the half widths of these X-ray diffraction peaks, the crystallite size of the bisbenzofuranone-based pigment is calculated by the Scherrer equation.

2. The near-infrared transmission light shielding film according to claim 1, further including a blue colorant as the colorant (B).

3. The near-infrared transmission light shielding film according to claim 2, wherein the blue colorant is copper phthalocyanine.

4. The near-infrared transmission light shielding film according to any one of claims 1 to 3, wherein the colored resin composition further comprises a polyamide-based polymer dispersant.

5. The near-infrared transmission light shielding film according to claim 4, wherein the polyamide-based polymer dispersant is a polyamide-based dispersant having a comb structure having a side chain including a polyester chain.

6. The near-infrared transmission light shielding film according to any one of claims 1 to 5, wherein the colored resin composition further comprises a photopolymerization initiator and a radically polymerizable compound, the colored resin composition including an alkali-soluble resin as the resin (A).

7. The near-infrared transmission light shielding film according to any one of claims 1 to 6, having a refractive index of 1.40 or more and 1.60 or less for light having a wavelength of 940 nm.

8. A decorative substrate comprising:
a substrate; and
the near-infrared transmission light shielding film according to any one of claims 1 to 7.

9. A decorative substrate for a decorative panel to hide a near-infrared sensor or a near-infrared camera, comprising:
a substrate; and
the near-infrared transmission light shielding film according to any one of claims 1 to 7.

## Patentansprüche

1. Abschirmungsfilm für nahes Infrarottransmissionslicht, umfassend ein gehärtetes Produkt der gefärbten Harzzusammensetzung, wobei die gefärbte Harzzusammensetzung Folgendes umfasst:
ein Harz (A);
ein Farbmittel (B); und
ein organisches Lösungsmittel (C), wobei die gefärbte Harzzusammensetzung mindestens ein Bisbenzofuranon-basiertes Pigment als das Farbmittel (B) einschließt, das eine Struktur aufweist, die durch eine der nachstehend beschriebenen allgemeinen Formeln (I) bis (III) dargestellt ist: 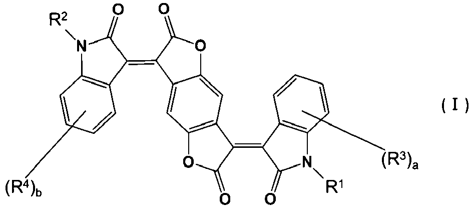 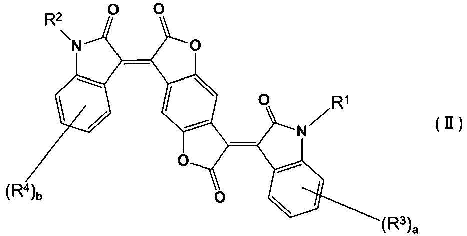 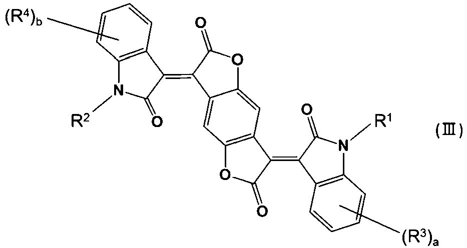
wobei in den allgemeinen Formeln (I) bis (III)
- R¹ und R² jeweils unabhängig ein Wasserstoffatom oder eine Alkylgruppe mit 1 bis 10 Kohlenstoffatomen darstellen,
- R³ und R⁴ jeweils unabhängig R¹⁰, OR¹¹, SR¹¹, COR¹¹, CONR¹¹R¹², NR¹¹COR¹², OCOR¹¹, COOR¹¹, SCOR¹¹, OCSR¹¹, COSR¹¹, CSOR¹¹, CN, ein Halogenatom oder eine Hydroxylgruppe darstellen, wobei R¹⁰ eine Alkylgruppe mit 1 bis 20 Kohlenstoffatomen, eine Arylgruppe mit 6 bis 30 Kohlenstoffatomen, eine Arylalkylgruppe mit 7 bis 30 Kohlenstoffatomen oder eine heterocyclische Gruppe mit 2 bis 20 Kohlenstoffatomen darstellt, ¹¹ und R¹² jeweils unabhängig ein Wasserstoffatom, eine Alkylgruppe mit 1 bis 20 Kohlenstoffatomen, eine Arylgruppe mit 6 bis 30 Kohlenstoffatomen, eine Arylalkylgruppe mit 7 bis 30 Kohlenstoffatomen oder eine heterocyclische Gruppe mit 2 bis 20 Kohlenstoffatomen darstellen, und
- a und b jeweils unabhängig eine ganze Zahl von 0 bis 4 darstellen.
wobei das Bisbenzofuranon-basierte Pigment eine Kristallitgröße von 10 nm oder mehr und 25 nm oder weniger in einem gefärbten Film aufweist, der aus einem gehärteten Produkt der gefärbten Harzzusammensetzung besteht,
wobei das Farbmittel (B) in einem Gehalt von 1 bis 17 Gew.-%, bezogen auf einen Gesamtfeststoffgehalt, enthalten ist,
wobei die Kristallitgröße des Bisbenzofuran-basierten Pigments wie folgt bestimmt wird: der Hauptpeak mit der höchsten Intensität wird bei einem Beugungswinkel 2θ von 7,8° oder mehr und 8,0° oder weniger unter Verwendung eines CuKa-Strahls als Röntgenquelle beobachtet. Aus den halben Breiten dieser Röntgenbeugungspeaks wird die Kristallitgröße des Bisbenzofuranon-basierten Pigments durch die Scherrer-Gleichung berechnet.

2. Abschirmungsfilm für nahes Infrarottransmissionslicht nach Anspruch 1, ferner umfassend ein blaues Farbmittel als das Farbmittel (B).

3. Abschirmungsfilm für nahes Infrarottransmissionslicht nach Anspruch 2, wobei das blaue Farbmittel Kupferphthalocyanin ist.

4. Abschirmungsfilm für nahes Infrarottransmissionslicht nach einem der Ansprüche 1 bis 3, wobei die gefärbte Harzzusammensetzung ferner ein Polyamid-basiertes Polymerdispergiermittel umfasst.

5. Abschirmungsfilm für nahes Infrarottransmissionslicht nach Anspruch 4, wobei das Polyamid-basierte Polymerdispergiermittel ein Polyamid-basiertes Dispergiermittel mit einer Kammstruktur mit einer Seitenkette ist, die eine Polyesterkette einschließt.

6. Abschirmungsfilm für nahes Infrarottransmissionslicht nach einem der Ansprüche 1 bis 5, wobei die gefärbte Harzzusammensetzung ferner einen Photopolymerisationsinitiator und eine radikalisch polymerisierbare Verbindung umfasst, wobei die gefärbte Harzzusammensetzung ein alkalilösliches Harz als das Harz (A) einschließt.

7. Abschirmungsfilm für nahes Infrarottransmissionslicht nach einem der Ansprüche 1 bis 6, der einen Brechungsindex von 1,40 oder mehr und 1,60 oder weniger für Licht mit einer Wellenlänge von 940 nm aufweist.

8. Dekoratives Substrat, umfassend:
ein Substrat; und
den Abschirmungsfilm für nahes Infrarottransmissionslicht nach einem der Ansprüche 1 bis 7.

9. Dekoratives Substrat für eine dekorative Platte, um einen Nahinfrarotsensor oder eine Nahinfrarotkamera zu verbergen, umfassend:
ein Substrat; und
den Abschirmungsfilm für nahes Infrarottransmissionslicht nach einem der Ansprüche 1 bis 7.

## Revendications

1. Film de protection contre la lumière transmise dans le proche infrarouge comprenant un produit durci de la composition de résine colorée, dans lequel la composition de résine colorée comprend :
une résine (A) ;
un colorant (B) ; et
un solvant organique (C), la composition de résine colorée incluant au moins un pigment à base de bisbenzofuranone en tant que colorant (B), qui a une structure représentée par l'une quelconque des formules générales (I) à (III) décrites ci-dessous : 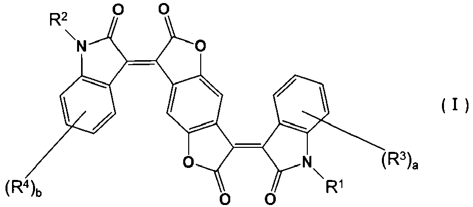 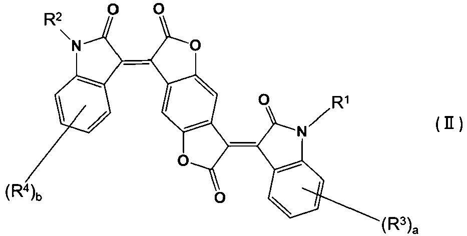 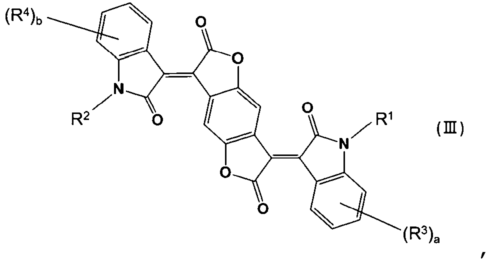
dans lequel dans les formules générales (I) à (III),
- R¹ et R² représentent chacun indépendamment un atome d'hydrogène ou un groupe alkyle ayant 1 à 10 atomes de carbone,
- R³ et R⁴ représentent chacun indépendamment R¹⁰, OR¹¹, SR¹¹, COR¹¹, CONR¹¹R¹², NR¹¹COR¹², OCOR¹¹, COOR¹¹, SCOR¹¹, OCSR¹¹, COSR¹¹, CSOR¹¹, CN, un atome d'halogène, ou un groupe hydroxyle, dans lequel R¹⁰ représente un groupe alkyle ayant 1 à 20 atomes de carbone, un groupe aryle ayant 6 à 30 atomes de carbone, un groupe arylalkyle ayant 7 à 30 atomes de carbone, ou un groupe hétérocyclique ayant 2 à 20 atomes de carbone, ¹¹ et R¹² représentent chacun indépendamment un atome d'hydrogène, un groupe alkyle ayant 1 à 20 atomes de carbone, un groupe aryle ayant 6 à 30 atomes de carbone, un groupe arylalkyle ayant 7 à 30 atomes de carbone, ou un groupe hétérocyclique ayant 2 à 20 atomes de carbone, et
- a et b représentent chacun indépendamment un nombre entier de 0 à 4,
dans lequel le pigment à base de bisbenzofuranone a une taille de cristallite de 10 nm ou plus et de 25 nm ou moins dans un film coloré constitué d'un produit durci de la composition de résine colorée,
dans lequel le colorant (B) est inclus à une teneur de 1 à 17 % en poids sur la base d'une teneur totale en solides,
dans lequel la taille de cristallite du pigment à base de bisbenzofuranone est déterminée comme suit : le pic principal ayant l'intensité la plus élevée est observé à un angle de diffraction 2θ de 7,8° ou plus et de 8,0° ou moins en utilisant un rayon CuKa en tant que source de rayons X. À partir des demi-largeurs de ces pics de diffraction de rayons X, la taille de cristallite du pigment à base de bisbenzofuranone est calculée par l'équation de Scherrer.

2. Film de protection contre la lumière transmise dans le proche infrarouge selon la revendication 1, incluant en outre un colorant bleu en tant que colorant (B).

3. Film de protection contre la lumière transmise dans le proche infrarouge selon la revendication 2, dans lequel le colorant bleu est la phtalocyanine de cuivre.

4. Film de protection contre la lumière transmise dans le proche infrarouge selon l'une quelconque des revendications 1 à 3, dans lequel la composition de résine colorée comprend en outre un dispersant polymère à base de polyamide.

5. Film de protection contre la lumière transmise dans le proche infrarouge selon la revendication 4, dans lequel le dispersant polymère à base de polyamide est un dispersant à base de polyamide ayant une structure en peigne ayant une chaîne latérale incluant une chaîne polyester.

6. Film de protection contre la lumière transmise dans le proche infrarouge selon l'une quelconque des revendications 1 à 5, dans lequel la composition de résine colorée comprend en outre un initiateur de photopolymérisation et un composé polymérisable par voie radicalaire, la composition de résine colorée incluant une résine soluble dans les alcalis en tant que résine (A).

7. Film de protection contre la lumière transmise dans le proche infrarouge selon l'une quelconque des revendications 1 à 6, ayant un indice de réfraction de 1,40 ou plus et de 1,60 ou moins pour une lumière ayant une longueur d'onde de 940 nm.

8. Substrat décoratif comprenant :
un substrat ; et
le film de protection contre la lumière transmise dans le proche infrarouge selon l'une quelconque des revendications 1 à 7.

9. Substrat décoratif pour un panneau décoratif pour cacher un capteur dans le proche infrarouge ou une caméra dans le proche infrarouge, comprenant :
un substrat ; et
le film de protection contre la lumière transmise dans le proche infrarouge selon l'une quelconque des revendications 1 à 7.
